# EUROPEAN PATENT APPLICATION

(11) **EP 4 628 907 A1**
(43) Date of publication of application: **08.10.2025**
(21) Application number: 23896759.0
(22) Date of filing: 28.11.2023
(51) Int. Cl.: G01R 31/12, H02H 3/00

(54) **ARC SIGNAL PROCESSING CIRCUIT AND METHOD, AND ELECTRICAL DEVICE**

(30) Priority: 29.11.2022 CN 202211516509
(71) Applicant: SHANGHAI CHINT LOW VOLTAGE ELECTRICAL TECHNOLOGY CO., LTD., Shanghai 201600 (CN)
(72) Inventor: WANG, Bangyue, Shanghai 201600 (CN); CAI, Youfeng, Shanghai 201600 (CN); SHI, Jianxin, Shanghai 201600 (CN); ZHUO, Li, Shanghai 201600 (CN); WANG, Qing, Shanghai 201600 (CN)
(74) Representative: Berggren Oy
(86) International application number: PCT/CN2023/134575
(87) International publication number: WO 2024/114610

(57) **Abstract**

Provided in the present application are an arc signal processing circuit and method, and an electrical device. The arc signal processing circuit includes: an amplification module, wherein an input end of the amplification module is connected to an arc signal, and the amplification module is used for amplifying the arc signal and then outputting an amplified signal; a band-pass filtering amplification module, wherein an input end of the band-pass filtering amplification module is electrically connected to an output end of the amplification module, and the band-pass filtering amplification module is used for filtering and amplifying the amplified signal outputted from the amplification module and then outputting a high-frequency signal in a preset frequency band; and a main control module, wherein the main control module is electrically connected to the output end of the amplification module, and the main control module is electrically connected to an output end of the band-pass filtering amplification module. In the present application, the amplitude of a half-wave signal and an arc energy value of the half-wave signal in a high-frequency signal are compared with corresponding threshold values, and whether an arc signal fault occurs is identified according to a comparison result, such that the accuracy in identification of arc fault of an electrical device is improved.

## Description

This application claims priority to the Chinese Patent Application No. 202211516509.2, filed before the China Patent Office on November 29, 2022, entitled "Arc Signal Processing Circuit and Method, and Electrical Device", the entire contents of which are incorporated by reference in this application.

### TECHNICAL FIELD

The present application relates to the technical field of electrical device, and in particular to an arc signal processing circuit and method, and electrical device.

### BACKGROUND

Arc fault is a common fault that may occur in electrical device. The specific causes of this fault are categorized variously. For example, when the electrical contacts are in poor contact or the insulating material in the electrical circuit is damaged, an arc fault will occur in the circuit, causing the electrical device to spontaneously combust. In more serious cases, it can also cause a fire. Therefore, if the faulty electrical device can be disconnected from the circuit when the arc fault occurs, a greatly improved safety can be achieved. It can be seen from this that how to identify whether an arc in a circuit has failed becomes the key to the problem.

### TECHNICAL PROBLEM

In previous arc signal sampling technologies, a single fixed-frequency signal is usually used as the basis for identifying arc faults. However, a single fault arc signal has the characteristics of strong randomness and unclear features, and it will be interfered by the load working noise, resulting in inaccurate identification for arc fault of electrical device.

### TECHNICAL SOLUTION

The present application provides an arc signal processing circuit and method, and an electrical device to improve the accuracy of the identification for arc fault of the electrical device.

In a first aspect, the present application provides an arc signal processing circuit, including:
an amplification module, having an input end connected to an arc signal, and configured to amplify the arc signal and output an amplified signal;
a band-pass filtering amplification module, having an input end electrically connected to an output end of the amplification module, and configured to filter and amplify the amplified signal output from the amplification module and output a high-frequency signal in a preset frequency band; and
a main control module, electrically connected to the output end of the amplification module and to an output end of the band-pass filtering amplification module, and configured to receive the amplified signal output from the amplification module and the high-frequency signal output from the band-pass filtering amplification module.

Optionally, in some embodiments of the present application, the main control module includes:
a high threshold voltage calculation unit, having an input end electrically connected to the output end of the band-pass filtering amplification module, and configured to calculate a count value of a signal whose voltage is greater than a high threshold voltage in the high-frequency signal output from the band-pass filtering amplification module; and
a low threshold voltage calculation unit, having an input end electrically connected to the output end of the band-pass filtering amplification module, and configured to calculate a count value of a signal whose voltage is greater than a low threshold voltage in the high-frequency signal output from the band-pass filtering amplification module; wherein the high threshold voltage is greater than the low threshold voltage;
wherein the main control module is configured to calculate an arc energy value of the high-frequency signal based on the count value of the signal whose voltage is greater than the high threshold voltage in the high-frequency signal, the count value of the signal whose voltage is greater than the low threshold voltage in the high-frequency signal, and an energy coefficient k, where k is an energy coefficient of the count value of the signal whose voltage is greater than the high threshold voltage in the high-frequency signal.

Optionally, in some embodiments of the present application, the amplification module includes:
an amplification circuit, having an input end connected to the arc signal; and
a high-pass filtering amplification circuit, having an input end electrically connected to an output end of the amplification circuit, and an output end electrically connected to the input end of the band-pass filtering amplification module and the main control module respectively.

Optionally, in some embodiments of the present application, the output end of the amplification circuit is electrically connected to the main control module.

Optionally, in some embodiments of the present application, the band-pass filtering amplification module includes:
a first band-pass filtering amplification circuit, having an input end electrically connected to an output end of the amplification module, and an output end electrically connected to the main control module; and
a second band-pass filtering amplification circuit, having an input end electrically connected to an output end of the amplification module, and an output end electrically connected to the main control module;
wherein a center frequency of the first band-pass filtering amplification circuit is smaller than a center frequency of the second band-pass filtering amplification circuit.

Optionally, in some embodiments of the present application, the high threshold voltage calculation unit includes:
a first high threshold voltage calculation unit, having an input end electrically connected to the output end of the first band-pass filtering amplification circuit, and configured to calculate a count value of a signal whose voltage is greater than a first high threshold voltage in a high-frequency signal output from the first band-pass filtering amplification circuit; and
a second high threshold voltage calculation unit, having an input end electrically connected to the output end of the second band-pass filtering amplification circuit, and configured to calculate a count value of a signal whose voltage is greater than a second high threshold voltage in a high-frequency signal output from the second band-pass filtering amplification circuit;
wherein the low threshold voltage calculation unit includes:
   a first low threshold voltage calculation unit, having an input end electrically connected to an output end of the first band-pass filtering amplification circuit, and configured to calculate a count value of a signal whose voltage is greater than a first low threshold voltage in the high-frequency signal output from the first band-pass filtering amplification circuit; and
   a second low threshold voltage calculation unit, having an input end electrically connected to the output end of the second band-pass filtering amplification circuit, and configured to calculate a count value of a signal whose voltage is greater than the second low threshold voltage in the high-frequency signal output from the second band-pass filtering amplification circuit;
   wherein the first high threshold voltage is greater than the first low threshold voltage; the second high threshold voltage is greater than the second low threshold voltage.

Optionally, in some embodiments of the present application, the band-pass filtering amplification module further includes:
a third band-pass filtering amplification circuit, having an input end electrically connected to the output end of the amplification module, and an output end electrically connected to the main control module;
wherein a center frequency of the third band-pass filtering amplification circuit is greater than the center frequency of the second band-pass filtering amplification circuit.

Optionally, in some embodiments of the present application, the high threshold voltage calculation unit further includes:
a third high threshold voltage calculation unit, having an input end electrically connected to the output end of the third band-pass filtering amplification circuit, and configured to calculate a count value of a signal whose voltage is greater than a third high threshold voltage in a high-frequency signal output from the third band-pass filtering amplification circuit;
wherein the low threshold voltage calculation unit further includes:
   a third low threshold voltage calculation unit, having an input end electrically connected to the output end of the third band-pass filtering amplification circuit, and configured to calculate a count value of a signal whose voltage is greater than a third low threshold voltage in the high-frequency signal output from the third band-pass filtering amplification circuit;
   wherein the third high threshold voltage is greater than the third low threshold voltage.

Optionally, in some embodiments of the present application, the high threshold voltage calculation unit includes:
a first comparator, having a first input end connected to a signal having a high threshold voltage, and a second input end electrically connected to the output end of the band-pass filtering amplification module; and
a first timer, having an input end electrically connected to an output end of the first comparator.

Optionally, in some embodiments of the present application, the low threshold voltage calculation unit includes:
a second comparator, having a first input end connected to a signal having a low threshold voltage, and a second input end electrically connected to the output end of the band-pass filtering amplification module; and
a second timer, having an input end electrically connected to an output end of the second comparator.

Optionally, in some embodiments of the present application, the arc signal processing circuit further includes:
a voltage sampling circuit, having an input end electrically connected to a circuit that generates an arc signal of an electrical device, and an output end electrically connected to the main control module, and configured to collect a voltage signal of the circuit that generates the arc signal.

In a second aspect, the present application provides an arc signal processing method, including:
obtaining a half-wave signal of an arc signal, setting M=M+1, where M is a number of the half-wave signals, and an initial value of M is zero;
amplifying the arc signal to obtain an amplified signal;
obtaining an amplitude of the half-wave signal according to the amplified signal;
filtering and amplifying the amplified signal to obtain a high-frequency signal of the half-wave signal in a preset frequency band;
calculating an arc energy value of the high-frequency signal;
determining whether the amplitude of the half-wave signal is greater than an amplitude threshold, and whether the arc energy value of the high-frequency signal is greater than an energy threshold; if so, determining that the arc signal includes a valid zero-crossing arc signal, and setting N=N+1, where N is a number of the valid zero-crossing arc signals, and an initial value of N is zero;
determining whether M is greater than or equal to a first threshold; if not, obtaining a next half-wave signal of the arc signal; if so, executing a next step; and
determining whether N is greater than or equal to a second threshold which is smaller than the first threshold; if so, executing a preset operation; if not, obtaining a next half-wave signal of the arc signal.

Optionally, in some embodiments of the present application, calculating the arc energy value of the high-frequency signal includes:
calculating a count value x of a signal whose voltage is greater than a high threshold voltage in the high-frequency signal;
calculating a count value y of a signal whose voltage is greater than a low threshold voltage in the high-frequency signal, wherein the high threshold voltage is greater than the low threshold voltage; and
calculating the arc energy value of the high-frequency signal according to x, y and an energy coefficient k, where k is an energy coefficient of x.

Optionally, in some embodiments of the present application, filtering and amplifying the amplified signal to obtain the high-frequency signal of the half-wave signal in the preset frequency band includes:
filtering and amplifying the amplified signal to obtain a high-frequency signal of the half-wave signal in at least two preset frequency bands that do not overlap with each other;
wherein calculating the arc energy value of the high-frequency signal includes:
   calculating an arc energy value of the high-frequency signal in the at least two preset frequency bands;
   wherein determining whether the amplitude of the half-wave signal is greater than the amplitude threshold, and whether the arc energy value of the high-frequency signal is greater than the energy threshold, includes:
      determining whether the amplitude of the half-wave signal is greater than the amplitude threshold, and whether the arc energy value of the high-frequency signal in each of the preset frequency bands is greater than the energy threshold; if so, determining that the arc signal includes the valid zero-crossing arc signal, and setting N=N+1, where N is the number of valid zero-crossing arc signals, and the initial value of N is zero.

Optionally, in some embodiments of the present application, calculating the arc energy value of the high-frequency signal includes:
calculating a count value x of a signal whose voltage is greater than a high threshold voltage in the high-frequency signal in each of the preset frequency bands,
calculating a count value y of a signal whose voltage is greater than a low threshold voltage in the high-frequency signal in each of the preset frequency bands, wherein the high threshold voltage is greater than the low threshold voltage,
calculating the arc energy value of the high-frequency signal in the at least two preset frequency bands according to x, y and an energy coefficient k, where k is an energy coefficient of x.

Optionally, in some embodiments of the present application, before determining whether the amplitude of the half-wave signal is greater than the amplitude threshold, and whether the arc energy value of the high-frequency signal is greater than the energy threshold, the arc signal processing method further includes:
obtaining a current rising rate of the amplified signal according to the amplified signal;
determining whether the current rising rate is greater than or equal to a rising rate threshold; if not, executing a next step; if so, issuing a fault alarm or disconnecting a circuit generating the arc signal.

Optionally, in some embodiments of the present application, amplifying the arc signal to obtain the amplified signal includes:
amplifying the arc signal to obtain the amplified signal; and
performing a high-pass filtering and amplification processing on the amplified signal to obtain a filtered amplified signal;
wherein filtering and amplifying the amplified signal to obtain the high-frequency signal of the half-wave signal in the preset frequency band includes:
   filtering and amplifying the filtered amplified signal to obtain the high-frequency signal of the half-wave signal in the preset frequency band.

In a third aspect, the present application provides an electrical device, characterized in including the above arc signal processing circuit.

### BENEFICIAL EFFECTS

Provided in the present application are an arc signal processing circuit and method, and an electrical device. The arc signal processing circuit includes: an amplification module, wherein an input end of the amplification module is connected to an arc signal, and the amplification module is used for amplifying the arc signal and then outputting an amplified signal; a band-pass filtering amplification module, wherein an input end of the band-pass filtering amplification module is electrically connected to an output end of the amplification module, and the band-pass filtering amplification module is used for filtering and amplifying the amplified signal outputted from the amplification module and then outputting a high-frequency signal in a preset frequency band; and a main control module, wherein the main control module is electrically connected to the output end of the amplification module, and the main control module is electrically connected to an output end of the band-pass filtering amplification module. In the present application, the amplitude of a half-wave signal and an arc energy value of the half-wave signal in a high-frequency signal are obtained by the main control module, and are compared with corresponding threshold values, and whether an arc signal fault occurs is identified according to a comparison result, such that the accuracy in identification of arc fault of an electrical device is improved.

### BRIEF DESCRIPTION OF THE DRAWINGS

In order to more clearly illustrate the technical solutions in the embodiments of the present application, the drawings required for use in the description of the embodiments will be briefly introduced below. Obviously, the drawings described below are only some embodiments of the present application. For those skilled in the art, other drawings can be obtained based on these drawings without inventive work.
FIG. 1 is a schematic diagram of a first structure of an arc signal processing circuit according to the present application.
FIG. 2 is a schematic diagram showing the current waveform of an AC signal and a voltage of the AC signal at a zero-crossing point.
FIG. 3 is a schematic diagram of a second structure of an arc signal processing circuit according to the present application.
FIG. 4 is a schematic diagram of a third structure of an arc signal processing circuit according to the present application.
FIG. 5 is a schematic diagram of a fourth structure of an arc signal processing circuit according to the present application.
FIG. 6 is a schematic diagram of a fifth structure of an arc signal processing circuit according to the present application.
FIG. 7 is a schematic diagram of a sixth structure of an arc signal processing circuit according to the present application.
FIG. 8 is a schematic diagram of a seventh structure of an arc signal processing circuit according to the present application.
FIG. 9 is a flow chart of an arc signal processing method according to a first embodiment of the present application.
FIG. 10 is a flow chart of step S50 of the arc signal processing method according to a first embodiment of the present application.
FIG. 11 is a flow chart of step S50 of the arc signal processing method according to a second embodiment of the present application.
FIG. 12 is a flow chart of an arc signal processing method according to a second embodiment of the present application.
FIG. 13 is a flow chart of an arc signal processing method according to a third embodiment of the present application.

### DETAILED DESCRIPTION OF THE EMBODIMENTS

The technical solutions in the embodiments of the present application will be clearly and completely described below in conjunction with the drawings in the embodiments of the present application. Obviously, the described embodiments are only part of the embodiments of the present application, rather than all the embodiments.

Based on the embodiments in this application, all other embodiments obtained by those skilled in the art without making any inventive work shall fall within the scope of protection of this application.

In the description of this application, it should be understood that the terms "a" and "an" are used for descriptive purposes only and cannot be understood as indicating or implying relative importance or implicitly indicating the number of the indicated technical features. Thus, a feature defined as "a" or "an" may explicitly or implicitly include one or more features. In the description of the present application, "plurality" means two or more than two, unless otherwise clearly and specifically defined.

In this application, the word "exemplary" is used to mean "serving as an example, instance, or illustration." Any embodiment described herein as "exemplary" is not necessarily to be construed as preferred or advantageous over other embodiments. The following description is given to enable any person skilled in the art to make and use the present application. In the following description, details are set forth for purposes of explanation. It will be appreciated that one skilled in the art will recognize that the present application may be practiced without these specific details. In other instances, well-known structures and processes are not described in detail to avoid obscuring the description of the present application with unnecessary detail. Thus, the present application is not intended to be limited to the embodiments shown, but is to be accorded the widest scope consistent with the principles and features disclosed herein.

The following first introduces some basic concepts involved in the embodiments of the present application:
Arc: it is a gas discharge phenomenon, a momentary spark produced when current passes through certain insulating media (such as air). An arc is a self-sustaining gas conduction (electrical conduction in an ionized gas) in which the majority of the charge carriers are electrons generated by primary electron emission. The metal surface of the contact causes electrons to escape due to primary electron emission (thermal ion emission, field emission or photoelectric emission), and the gas atoms or molecules in the gap will produce electrons and ions due to ionization (impact ionization, photoionization and thermal ionization). In addition, electron or ion bombardment of the emitting surface will cause secondary electron emission. When the ion concentration in the gap is large enough, the gap is electrically broken down and an arc occurs.

Arc fault: it refers to an electrical fault in which an arc occurs in a live line without human intention. Specifically, according to the connection relationship between the arc and the circuit when the arc fault occurs, the arc fault (AF) can be divided into series arc fault (SAF), parallel arc fault (PAF), grounding arc fault (GAF), etc.

The present application provides an arc signal processing circuit and method, and electrical device, which are described in detail below. It should be noted that the description order of the following embodiments is not intended to limit the preferred order of the embodiments of the present application.

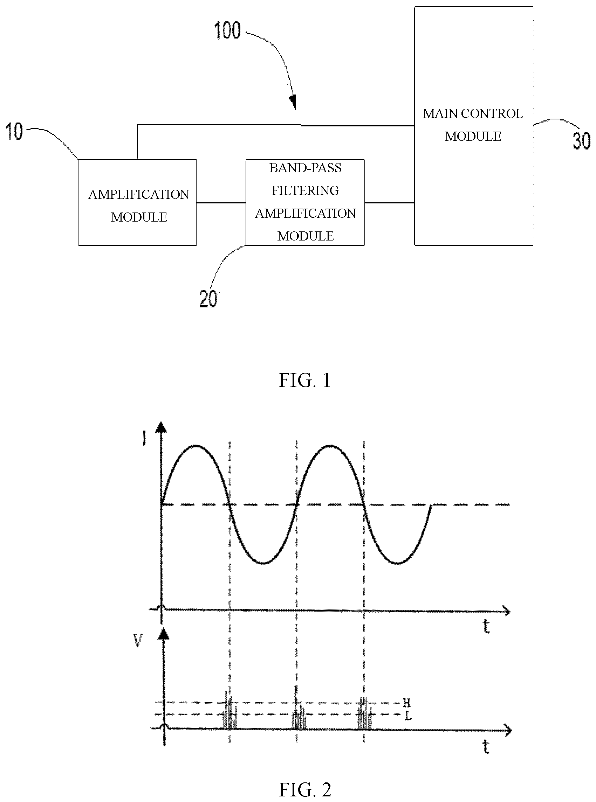

Please refer to FIG. 1, which is a schematic diagram of a first structure of an arc signal processing circuit 100 according to the present application. The present application provides an arc signal processing circuit 100, which includes an amplification module 10, a band-pass filtering amplification module 20 and a main control module 30.

The input end of the amplification module 10 is connected to the arc signal. The input end of the band-pass filtering amplification module 20 is electrically connected to the output end of the amplification module 10. The band-pass filtering amplification module 20 is configured to filter and amplify the amplified signal output from the amplification module 10 and then output a high-frequency signal in a preset frequency band. The main control module 30 is electrically connected to the output end of the amplification module 10. The main control module 30 is electrically connected to the output end of the band-pass filtering amplification module 20. The main control module 30 is configured to receive the amplified signal output from the amplification module 10 and the high-frequency signal output from the band-pass filtering amplification module 20.

To obtain a half-wave signal of an arc signal, the main control module sets M=M+1, where M is the number of half-wave signals and the initial value of M is zero; the main control module obtains the amplitude of the half-wave signal according to the amplified signal and obtains the arc energy of the high-frequency signal of the half-wave signal in a preset frequency band according to the high-frequency signal; when the amplitude of the half-wave signal is greater than the amplitude threshold, and the arc energy value of the high-frequency signal is greater than the energy threshold, the main control module sets N=N+1, where N is the number of valid zero-crossing arc signals and the initial value of N is zero; when M is greater than or equal to a first threshold, the main control module determines whether N is greater than or equal to a second threshold, where the first threshold is greater than the second threshold, and if N is greater than or equal to the second threshold, the main control module executes a preset operation, and if N is less than the second threshold, the main control module obtains the next half-wave signal of the arc signal.

In actual situations, there are many equipment or electrical devices that generate arc signals. For example, when a switching device disconnects the circuit, the voltage and current reach a certain value, and a strong white light is generated between the contacts just after the contacts are separated, and an arc is generated. At this time, the arc signal processing circuit 100 can be connected to the switch of the electrical device. Therefore, FIG. 1 does not show the connection structure between the amplification module 10 and the equipment generating the arc signal. Specifically, the connection can be performed according to the equipment sending the arc signal, which is not limited here.

Furthermore, in some embodiments, the frequency of the high-frequency signal is greater than 500 kHz.

The present application utilizes an amplification module 10 to obtain an amplified signal of an arc signal, and then transmits the amplified signal to a band-pass filtering amplification module 20 and a main control module 30 respectively. The band-pass filtering amplification module 20 filters and amplifies the amplified signal to obtain a high-frequency signal of a half-wave signal in a preset frequency band. When an arc fault occurs in the bypass of the device, the high-frequency information caused by the arc will be transmitted to the circuit under test through the power line, while the low-frequency information generated by the arc will not be transmitted to the circuit under test in large quantities. Therefore, by obtaining a high-frequency signal of a preset frequency band of the arc signal, the fault information of the arc signal can be obtained more accurately. According to the present application, after obtaining the high-frequency signal of the amplified signal and the half-wave signal in the preset frequency band, it obtains the amplitude of the half-wave signal and the arc energy value of the high-frequency signal by using the main control module 30, and then compares the amplitude of the half-wave signal and the arc energy value of the high-frequency signal with the corresponding threshold value, and identifies whether the arc signal has a fault based on the comparison result, thereby improving the accuracy of the identification for arc fault of electrical device.

Since the amplitude of the arc signal of a fault will be large, the present application uses the amplitude of the half-wave signal as a criterion for determining whether there is an arc fault. The energy of the arc signal of a fault is large in the high-frequency band, so the present application uses the arc energy value of the high-frequency signal as another criterion for determining whether there is an arc fault, thereby improving the accuracy for the identification for arc fault of electrical device.

Please refer to FIG. 2, which is a schematic diagram showing the current waveform of an AC signal and a voltage of the AC signal at a zero-crossing point. There will be 2 zero-crossing signals (intersections with the Y-axis) in each actual current cycle of the AC signal, that is, there will be at most 2 arc signal waveforms in each cycle of the actual current, that is, two waveforms correspond to 2 zero-crossing arc signals. The actual current will generate arc signals at the zero-crossing point, wherein the voltage amplitudes of some arc signals will be greater than the first threshold, while the voltage amplitudes of some arc signals will be greater than the second threshold and less than the first threshold. Under normal circumstances, the more violent the arc is, the greater the amplitude of the arc signal is, and the worse the continuity of the arc signal is. Then, compared with the normal arc signal, the number of signals in the faulty arc signal whose voltage is greater than the first threshold increases, while the number of signals whose voltage is greater than the second threshold decreases.

Specifically, after obtaining the half-wave signal of the arc signal, the main control module 30 sets M=M+1, where M is the number of half-wave signals and the initial value of M is zero; when the amplitude of the half-wave signal is greater than the amplitude threshold, and the arc energy value of the high-frequency signal is greater than the energy threshold, the arc signal includes a valid zero-crossing arc signal, and the main control module 30 sets N=N+1, where N is the number of valid zero-crossing arc signals and the initial value of N is zero; when M is greater than or equal to the first threshold, and N is greater than or equal to the second threshold, and the first threshold is greater than the second threshold, the main control module 30 determines that an arc fault has occurred, and issues a fault alarm or disconnects the circuit that generates the arc signal. The first threshold and the second threshold are determined by the current of the circuit that generates the arc signal. The main control module 30 can obtain the current value by obtaining the amplified signal to determine the first threshold and the second threshold. In addition, the main control module 30 may also obtain the arc signal by accessing the arc signal, or may obtain it indirectly.

In an example, when the actual current of the circuit generating the arc signal is 3A, the relationship between the current value and the threshold is determined by a preset correspondence table, then it can be determined that the first threshold of the number of arc signal waveforms is 50, and the second threshold of the number of arc signal waveforms can be is 30; if the actual current of the circuit generating the arc signal is 6A, the first threshold may be 40 and the second threshold may be 25, and so on, thereby achieving the purpose that the larger the arc current, the faster the action time. The arc signal has a sine or cosine waveform, so there will be 2 zero-crossing signals (intersections with the Y-axis) in each actual current cycle of the AC signal, that is, there will be at most 2 arc signal waveforms in each cycle of the actual current, that is, two waveforms correspond to 2 zero-crossing arc signals. In addition, whether the arc signal waveform is valid can be determined based on the magnitude of the current change near the zero crossing of the waveform. For example, for a 3A electrical device, the current changes in a sinusoidal manner during normal operation, but when an arc exists, there will be a flat shoulder phenomenon near the zero crossing point of the current, that is, the current change is reduced. If the main control module 30 detects that the current change is lower than the set threshold, it can be determined that the arc in the corresponding period is abnormal, otherwise it is normal. In summary, for example, when the current in the current loop is 3A, if there are 30 valid zero-crossing arc signals in 50 continuous half-wave signals, it is determined that an arc fault has occurred, and a fault alarm is issued or the loop generating the arc signal is disconnected; otherwise, it is determined that no arc fault exists.

The main control module 30 may include a microcontroller chip or other control chips.

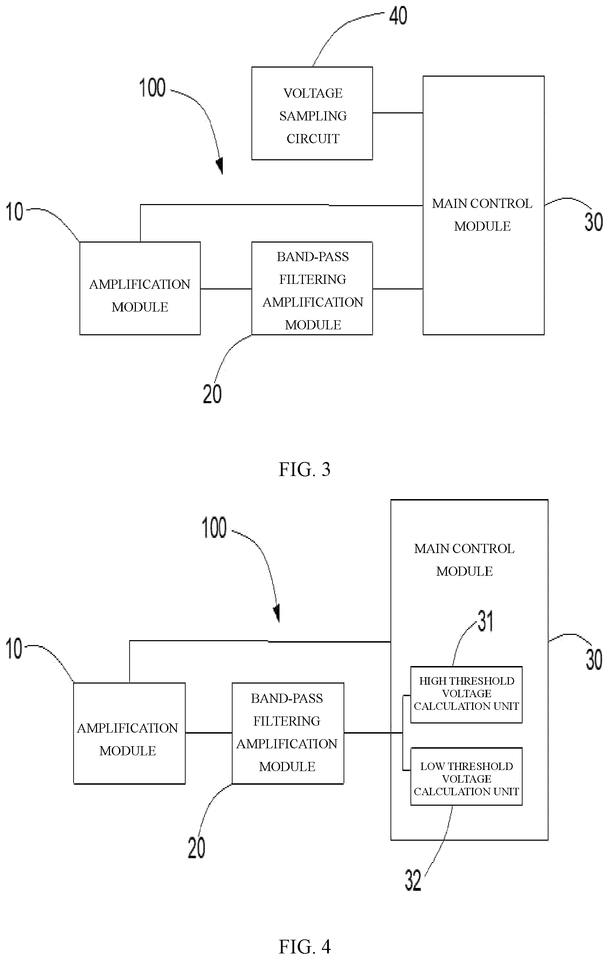

Please refer to FIG. 3, which is a schematic diagram of a second structure of an arc signal processing circuit 100 according to the present application. The arc signal is generated by an electrical device. The embodiment of FIG. 3 is different from the arc signal processing circuit 100 of FIG. 1 in that the arc signal processing circuit 100 further includes a voltage sampling circuit 40.

The voltage sampling circuit 40 has an input end electrically connected to a circuit that generates an arc signal of an electrical device. The voltage sampling circuit 40 is configured to collect a voltage signal of the circuit that generates the arc signal. The output end of the voltage sampling circuit 40 is electrically connected to the main control module 30.

According to the present application, by using the voltage sampling circuit 40, the voltage signal of the circuit that generates the arc signal is obtained, and the main control module 30 is configured to obtain the voltage frequency F through the voltage signal, so that it can be known that under normal circumstances, the arc signal will have two zero crossing points every 1/F second.

Please refer to FIG. 4, which is a schematic diagram of a third structure of an arc signal processing circuit 100 according to the present application. The embodiment of FIG. 4 is different from the arc signal processing circuit 100 of FIG. 1 in that the main control module 30 includes:
a high threshold voltage calculation unit 31, the input end of which is electrically connected to the output end of the band-pass filtering amplification module 20, and the high threshold voltage calculation unit 31 is configured to calculate the count value of the signal whose voltage is greater than the high threshold voltage in the high-frequency signal output from the band-pass filtering amplification module 20;
a low threshold voltage calculation unit 32, the input end of which is electrically connected to the output end of the band-pass filtering amplification module 20, and the low threshold voltage calculation unit 32 is configured to calculate the count value of the signal whose voltage is greater than the low threshold voltage in the high-frequency signal output from the band-pass filtering amplification module 20; the high threshold voltage is greater than the low threshold voltage;
wherein the main control module is configured to calculate the arc energy value of the high-frequency signal based on the count value of the signal whose voltage is greater than the high threshold voltage in the high-frequency signal, the count value of the signal whose voltage is greater than the low threshold voltage in the high-frequency signal, and the energy coefficient k, where k is the energy coefficient of the count value of the signal whose voltage is greater than the high threshold voltage in the high-frequency signal.

Therefore, according to the present application, by using the high threshold voltage calculation unit 31, the count value x of the signal whose voltage is greater than the high threshold voltage in the high-frequency signal output from the band-pass filtering amplification module 20 is obtained, and by using the low threshold voltage calculation unit 32, the count value y of the signal whose voltage is greater than the low threshold voltage in the high-frequency signal output from the band-pass filtering amplification module 20 is obtained, and then the arc energy value W of the high-frequency signal is calculated according to x, y and the energy coefficient k, where k is the energy coefficient of x. Specifically, the arc energy value W of the high-frequency signal can be obtained by multiplying x, y and k. The energy coefficient can be obtained by looking up the relationship table between the energy coefficient and the frequency range based on the preset frequency, or can be obtained by calculation according to the preset frequency.

Furthermore, the high threshold voltage calculation unit 31 and the low threshold voltage calculation unit 32 may be arranged inside the microcontroller chip, or may be arranged outside the microcontroller chip and electrically connected to the microcontroller chip.

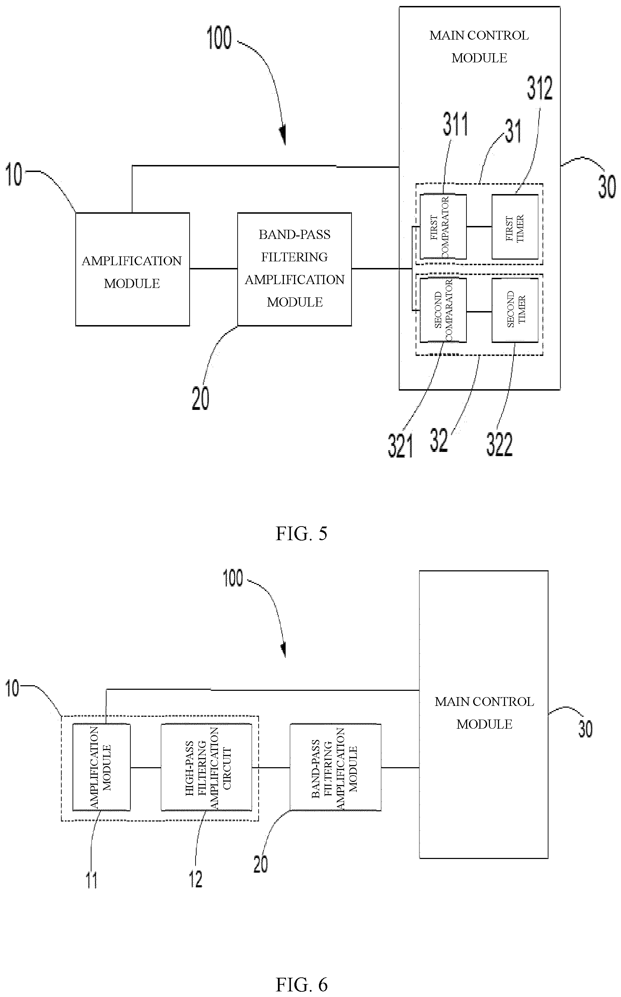

Please refer to FIG. 5, which is a schematic diagram of a fourth structure of an arc signal processing circuit 100 according to the present application. The embodiment of FIG. 5 is different from the arc signal processing circuit 100 of FIG. 4 in that the high threshold voltage calculation unit 31 includes:
a first comparator 311, having a first input end connected to a signal of a high threshold voltage, and a second input end electrically connected to an output end of the band-pass filtering amplification module 20;
a first timer 312, having an input end electrically connected to the output end of the first comparator 311.

That is, when a signal whose voltage is greater than the high threshold voltage appears in the high-frequency signal output from the band-pass filtering amplification module 20, the output end of the first comparator 311 outputs a signal to the input end of the first timer 312, and the calculation of the first timer 312 is increased by 1 until reaching the count value x of the signal whose voltage is greater than the high threshold voltage in the high-frequency signal output from the band-pass filtering amplification module 20.

The low threshold voltage calculation unit 32 includes:
a second comparator 321, having a first input end connected to a signal of a low threshold voltage, and a second input end electrically connected to an output end of the band-pass filtering amplification module 20;
a second timer 322, having an input end electrically connected to the output end of the second comparator 321.

That is, when a signal whose voltage is greater than the lower threshold voltage appears in the high-frequency signal output from the band-pass filtering amplification module 20, the output end of the second comparator 321 outputs a signal to the input end of the second timer 322, and the calculation of the second timer 322 is increased by 1 until reaching the count value y of the signal whose voltage is greater than the lower threshold voltage in the high-frequency signal output from the band-pass filtering amplification module 20.

Please refer to FIG. 6, which is a schematic diagram of a fifth structure of an arc signal processing circuit 100 according to the present application. The embodiment of FIG. 6 is different from the arc signal processing circuit 100 of FIG. 1 in that the amplification module 10 includes:
an amplification circuit 11, having an input end connected to an arc signal;
a high-pass filtering amplification circuit 12, having an input end electrically connected to the output end of the amplification circuit 11, and an output end electrically connected to the input end of the band-pass filtering amplification module 20 and the main control module 30.

The amplification circuit 11 is configured to amplify the arc signal to obtain an amplified signal, and the high-pass filtering amplification circuit 12 is configured to filter and amplify the amplified signal to obtain a filtered amplified signal, and transmit the filtered amplified signal to the band-pass filtering amplification module 20 and the main control circuit respectively.

According to the above embodiment, after the arc signal is amplified multiple times, the detection accuracy can be more effectively improved. However, due to the limitations of the carrying capacity of the circuit board itself and the corresponding production cost, the number of amplifications can be set to 3 times, that is, the amplification circuit 11, the high-pass filtering amplification circuit 12 and the band-pass filtering amplification module 20 are configured to amplify three times. In this way, a certain cost can be saved while meeting the effective detection accuracy. For example, modern electrical device are made in a small size as much as possible for portability. For example, televisions are getting thinner and thinner, humidifiers are getting smaller and smaller, and so on. Accordingly, the space left for circuit boards inside the electrical device is also getting smaller and smaller. The more modules are integrated on a smaller circuit board, the more cost of the electrical device incurs due to the increased technical difficulty and the increase in the number of integrated modules. Therefore, integrating a three-stage amplification module can effectively avoid cost increases.

Furthermore, in some embodiments, the output end of the amplification circuit 11 is electrically connected to the main control module 30.

According to the present application, by using the main control module 30, the amplified signal of the amplification circuit 11 is obtained. The main control module 30 can obtain the actual current of the circuit that generates the arc signal. The main control module 30 can determine the relationship between the current value and the threshold through a preset correspondence table based on the actual current of the circuit that generates the arc signal, and can determine the first threshold and the second threshold of the number of arc signal waveforms.

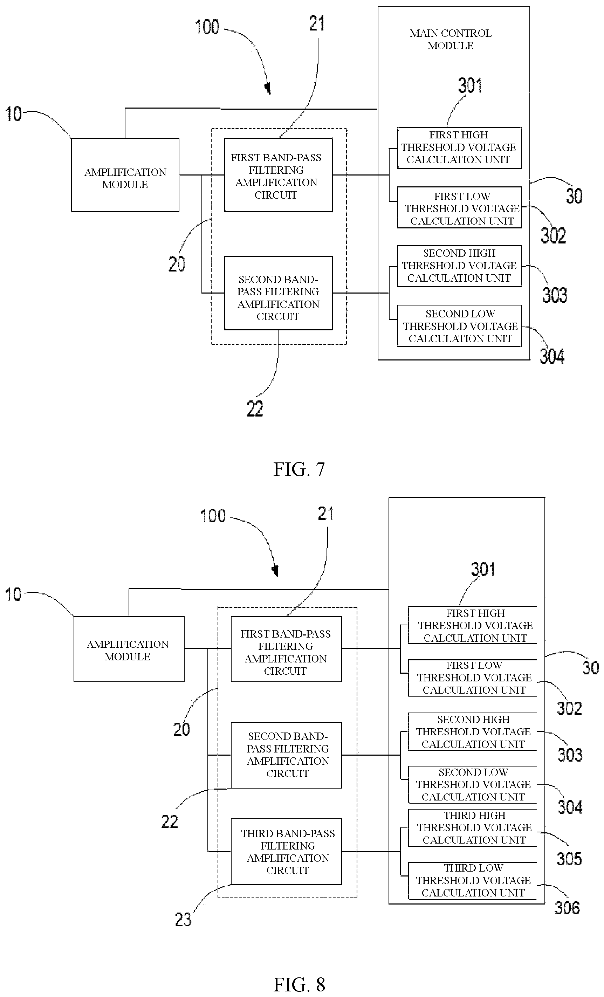

Please refer to FIG. 7, which is a schematic diagram of a sixth structure of an arc signal processing circuit 100 according to the present application. The embodiment of FIG. 7 is different from the arc signal processing circuit 100 of FIG. 1 in that the band-pass filtering amplification module 20 includes:
a first band-pass filtering amplification circuit 21, having an input end electrically connected to the output end of the amplification module 10, and an output end electrically connected to the main control module 30;
a second band-pass filtering amplification circuit 22, having an input end electrically connected to the output end of the amplification module 10, and an output end electrically connected to the main control module 30;
wherein the center frequency of the first band-pass filtering amplification circuit 21 is smaller than the center frequency of the second band-pass filtering amplification circuit 22.

The band-pass filtering amplification module 20 of the present application is provided with two band-pass filtering amplification circuits 11, namely, the first band-pass filtering amplification circuit 21 and the second band-pass filtering amplification circuit 22. Therefore, the amplified signal output from the amplification module 10 passes through the first band-pass filtering amplification circuit 21 and the second band-pass filtering amplification circuit 22 respectively to obtain the high-frequency signal of the half-wave signal in the first preset frequency band and the high-frequency signal of the half-wave signal in the second preset frequency band. After the main control module 30 obtains the high-frequency signal of the half-wave signal in the first preset frequency band and the high-frequency signal of the half-wave signal in the second preset frequency band, it calculates the first arc energy value of the high-frequency signal of the half-wave signal in the first preset frequency band and the second arc energy value of the high-frequency signal of the half-wave signal in the second preset frequency band. The amplitude of the half-wave signal, the first arc energy value and the second arc energy value are then compared with the corresponding threshold values, and whether the arc signal is faulty is identified based on the comparison result, thereby improving the accuracy of the identification for arc fault of electrical device. Since there is only a high-frequency signal in a single preset frequency band, there may be an abnormal arc signal, which may lead to an error in the identification for the arc fault. By adding high-frequency signals in different preset frequency bands, the stability of the obtained arc energy value can be guaranteed. That is, if the arc signal has high-frequency signals in multiple frequency bands, the probability of an arc fault is particularly high.

The first energy threshold of the high-frequency signal of the half-wave signal in the first preset frequency band and the second energy threshold of the high-frequency signal of the half-wave signal in the second preset frequency band may be same or different. The specific value can be determined according to practical needs.

Further, in some embodiments, the passband frequency range of the first band-pass filtering amplification circuit 21 is 500 kHz to 2 MHz, and the passband frequency range of the second band-pass filtering amplification circuit 22 is 3 MHz to 6 MHz. That is, the center frequency of the first band-pass filtering amplification circuit 21 is 1.25 MHz, and the center frequency of the second band-pass filtering amplification circuit 22 is 4.5 MHz.

Furthermore, in some embodiments, the high threshold voltage calculation unit 31 includes:
a first high threshold voltage calculation unit 301, having an input end electrically connected to the output end of the first band-pass filtering amplification circuit 21, and configured to calculate the count value of the signal whose voltage is greater than the first high threshold voltage in the high-frequency signal output from the first band-pass filtering amplification circuit 21;
a second high threshold voltage calculation unit 303, having an input end electrically connected to the output end of the second band-pass filtering amplification circuit 22, and configured to calculate the count value of the signal whose voltage is greater than the second high threshold voltage in the high-frequency signal output from the second band-pass filtering amplification circuit 21;
the low threshold voltage calculation unit 32 includes:
   a first low threshold voltage calculation unit 302, having an input end electrically connected to the output end of the first band-pass filtering amplification circuit 21, and configured to calculate the count value of the signal whose voltage is greater than the first low threshold voltage in the high-frequency signal output from the first band-pass filtering amplification circuit 21;
   a second low threshold voltage calculation unit 304, having an input end electrically connected to the output end of the second band-pass filtering amplification circuit 22, and configured to calculate the count value of the signal whose voltage is greater than the second low threshold voltage in the high-frequency signal output from the second band-pass filtering amplification circuit 22;
   wherein the first high threshold voltage is greater than the first low threshold voltage; the second high threshold voltage is greater than the second low threshold voltage.

That is, the first high threshold voltage calculation unit 301 is configured to calculate the count value x1 of the signal whose voltage is greater than the first high threshold voltage in the high-frequency signal output from the first band-pass filtering amplification circuit 21, and the first low threshold voltage calculation unit 302 is configured to calculate the count value y1 of the signal whose voltage is greater than the first low threshold voltage in the high-frequency signal output from the first band-pass filtering amplification circuit 21. The main control module 30 is configured to calculate the arc energy value W1 of the high-frequency signal in the first preset frequency band according to x1, y1 and the energy coefficient k1, where k1 is the energy coefficient of x1. Specifically, the arc energy value W1 of the high-frequency signal in the first preset frequency band can be obtained by multiplying x1, y1 and k1; the second high threshold voltage calculation unit 303 is configured to calculate the count value x2 of the signal whose voltage is greater than the second high threshold voltage in the high-frequency signal output from the second band-pass filtering amplification circuit 22; the second low threshold voltage calculation unit 304 is configured to calculate the count value y2 of the signal whose voltage is greater than the second low threshold voltage in the high-frequency signal output from the second band-pass filtering amplification circuit 22; the main control module 30 is configured to calculate the arc energy value W2 of the high-frequency signal in the second preset frequency band according to x2, y2 and the energy coefficient k2, where k2 is the energy coefficient of x2. Specifically, the arc energy value W2 of the high-frequency signal in the second preset frequency band can be obtained by multiplying x2, y2 and k2.

Please refer to FIG. 8, which is a schematic diagram of a seventh structure of an arc signal processing circuit 100 according to the present application. The embodiment of FIG. 8 is different from the arc signal processing circuit 100 of FIG. 7 in that the band-pass filtering amplification module 20 further includes:
a third band-pass filtering amplification circuit 23, having an input end electrically connected to the output end of the amplification module 10, and an output end electrically connected to the main control module 30;
wherein the center frequency of the third band-pass filtering amplification circuit 23 is greater than the center frequency of the second band-pass filtering amplification circuit 22.

The band-pass filtering amplification module 20 of the present application is provided with a third band-pass filtering amplification circuit 23 on the basis of provision of the first band-pass filtering amplification circuit 21 and the second band-pass filtering amplification circuit 22. Therefore, the amplified signal output from the amplification module 10 is passed through the third band-pass filtering amplification circuit 23 to obtain a high-frequency signal of the third band-pass filtering amplification circuit 23 in the preset frequency band. After the main control module 30 obtains the high-frequency signal of the half-wave signal in the third preset frequency band, it calculates the third arc energy value of the high-frequency signal of the half-wave signal in the third preset frequency band. The amplitude of the half-wave signal, the first arc energy value, the second arc energy value and the third arc energy value are then compared with the corresponding thresholds, and whether the arc signal has a fault is identified based on the comparison result, thereby improving the accuracy of the identification for arc fault of electrical device. Since there is only a high-frequency signal in a single preset frequency band, there may be an abnormal arc signal, which may lead to an error in the identification for the arc fault. According to the present application, high-frequency signals in three different preset frequency bands are obtained, and thus the stability of the obtained arc energy value can be further ensured. That is, if the arc signal has high-frequency signals in multiple frequency bands, the probability of an arc fault is particularly high.

Further, in some embodiments, the passband frequency range of the third band-pass filtering amplification circuit 23 is 8 MHz to 12 MHz, that is, the center frequency of the third band-pass filtering amplification circuit 23 is 10 MHz. Furthermore, the high threshold voltage calculation unit 31 further includes:
a third high threshold voltage calculation unit 305, having an input end electrically connected to the output end of the third band-pass filtering amplification circuit 23, and configured to calculate the count value of the signal whose voltage is greater than the third high threshold voltage in the high-frequency signal output from the third band-pass filtering amplification circuit 23;
the low threshold voltage calculation unit 32 further includes:
   a third low threshold voltage calculation unit 306, having an input end electrically connected to the output end of the third band-pass filtering amplification circuit 23, and configured to calculate the count value of the signal whose voltage is greater than the third low threshold voltage in the high-frequency signal output from the third band-pass filtering amplification circuit 23;
   wherein the third high threshold voltage is greater than the third low threshold voltage.

That is, the third high threshold voltage calculation unit 305 is configured to calculate the count value x3 of the signal whose voltage is greater than the third high threshold voltage in the high-frequency signal output from the third band-pass filtering amplification circuit 23, and the third low threshold voltage calculation unit 306 is configured to calculate the count value y3 of the signal whose voltage is greater than the third low threshold voltage in the high-frequency signal output from the third band-pass filtering amplification circuit 23. The main control module 30 is configured to calculate the arc energy value W3 of the high-frequency signal in the third preset frequency band based on x3, y3 and the energy coefficient k3, where k3 is the energy coefficient of x3. Specifically, the arc energy value W3 of the high-frequency signal in the first preset frequency band can be obtained by multiplying x3, y3 and k3.

Of course, the band-pass filtering amplification module not only includes the first band-pass filtering amplification circuit, the second band-pass filtering amplification circuit, and the third band-pass filtering amplification circuit, but also can be provided with several band-pass filtering amplification circuits according to actual needs, and no specific limitation is made here.

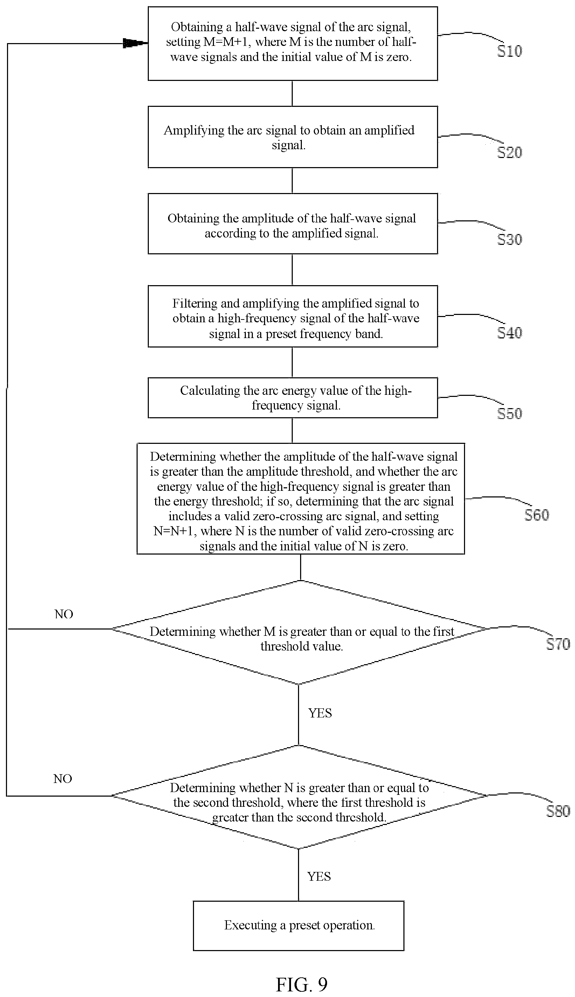

Please refer to FIG. 9, is a flow chart of an arc signal processing method according to a first embodiment of the present application. Correspondingly, the embodiments of the present application further provide an arc signal processing method, which includes the following steps:
S10, obtaining a half-wave signal of the arc signal, setting M=M+1, where M is the number of half-wave signals and the initial value of M is zero; that is, each time a half-wave signal of the arc signal is obtained, the value of M is automatically increased by 1;
S20, amplifying the arc signal to obtain an amplified signal;
S30, obtaining the amplitude of the half-wave signal according to the amplified signal;
S40, filtering and amplifying the amplified signal to obtain a high-frequency signal of the half-wave signal in a preset frequency band;
S50, calculating the arc energy value of the high-frequency signal;
S60, determining whether the amplitude of the half-wave signal is greater than the amplitude threshold, and whether the arc energy value of the high-frequency signal is greater than the energy threshold; if so, determining that the arc signal includes a valid zero-crossing arc signal, and setting N=N+1, where N is the number of valid zero-crossing arc signals and the initial value of N is zero;
S70, determining whether M is greater than or equal to the first threshold value; if not, obtaining the next half-wave signal of the arc signal, that is, executing step S10; if yes, executing the next step, that is, executing step S80;
S80, determining whether N is greater than or equal to the second threshold, where the first threshold is greater than the second threshold; if so, executing the preset operation; if not, obtaining the next half-wave signal of the arc signal, that is, executing step S10; wherein the preset operation may be to issue a fault alarm or disconnect a circuit generating an arc signal.

According to the present application, after obtaining the arc signal, setting M=M+1, where M is the number of half-wave signals and the initial value of M is zero; when the amplitude of the half-wave signal is greater than the amplitude threshold, and the arc energy value of the high-frequency signal is greater than the energy threshold, determining that the arc signal includes a valid zero-crossing arc signal, and setting N=N+1, where N is the number of valid zero-crossing arc signals and the initial value of N is zero; when M is greater than or equal to the first threshold, and N is greater than or equal to the second threshold, where the first threshold is greater than the second threshold, it is determined that an arc fault has occurred, and a fault alarm is issued or the circuit generating the arc signal is disconnected. The first threshold and the second threshold are determined by the current of the loop that generates the arc signal. The first threshold and the second threshold can be determined by obtaining the current value obtained from the amplified signal.

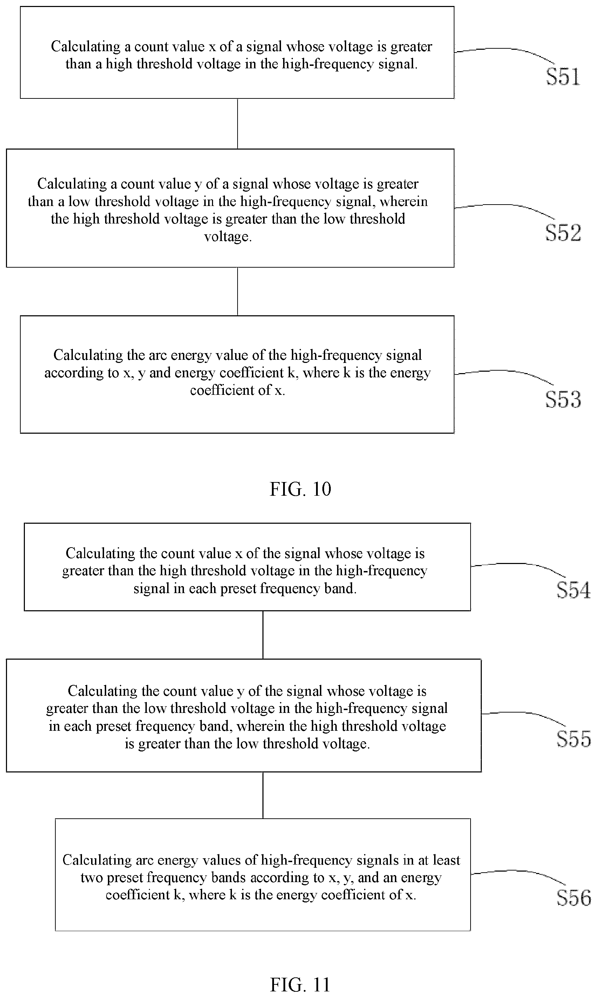

Please refer to FIG. 10, which is a flow chart of step S50 of the arc signal processing method according to a first embodiment of the present application. In this embodiment, step S50 includes:
S51, calculating a count value x of a signal whose voltage is greater than a high threshold voltage in the high-frequency signal;
S52, calculating a count value y of a signal whose voltage is greater than a low threshold voltage in the high-frequency signal, wherein the high threshold voltage is greater than the low threshold voltage;
S53, calculating the arc energy value of the high-frequency signal according to x, y and energy coefficient k, where k is the energy coefficient of x.

Therefore, according to the present application, it obtains the count value x of the signal whose voltage is greater than the high threshold voltage in the high-frequency signal, obtains the count value y of the signal whose voltage is greater than the low threshold voltage in the high-frequency signal, and then calculates the arc energy value W of the high-frequency signal according to x, y and the energy coefficient k, where k is the energy coefficient of x. Specifically, the arc energy value W of the high-frequency signal can be obtained by multiplying x, y and k.

Please refer to FIG. 11, which is a flow chart of step S50 of the arc signal processing method according to a second embodiment of the present application. The arc signal processing method provided in this embodiment is different from that provided in FIG. 9 in that:

Step S40 includes:
filtering and amplifying the amplified signal to obtain a high-frequency signal of the half-wave signal in at least two preset frequency bands, wherein the at least two preset frequency bands do not overlap with each other;

Step S50 includes:
calculating arc energy values of high-frequency signals in at least two preset frequency bands;

Step S60 includes:
determining whether the amplitude of the half-wave signal is greater than the amplitude threshold, and whether the arc energy value of the high-frequency signal in each preset frequency band is greater than the energy threshold; if so, determining that the arc signal includes a valid zero-crossing arc signal, setting N=N+1, where N is the number of valid zero-crossing arc signals, and the initial value of N is zero.

That is, according to the present application, it obtains a high-frequency signal of a half-wave signal in at least two preset frequency bands by filtering and amplifying the amplified signal, wherein the at least two preset frequency bands do not overlap with each other. The energy thresholds of the high-frequency signals in the at least two preset frequency bands can be the same or different, and the specific value can be set based on actual needs. Therefore, according to the present application, it can calculate the arc energy value of the high-frequency signal of at least two preset frequency bands, and then compare the amplitude of the half-wave signal and the arc energy value of the high-frequency signal of the at least two preset frequency bands with the corresponding threshold value, and identify whether the arc signal has a fault based on the comparison result, thereby improving the accuracy of identification for arc fault of electrical device. Since there is only a high-frequency signal in a single preset frequency band, there may be an abnormal arc signal, which may lead to an error in identification for the arc fault. By obtaining high-frequency signals in at least two preset frequency bands that do not overlap with each other, the stability of the obtained arc energy value can be guaranteed. That is, if the arc signal has high-frequency signals in multiple frequency bands, the probability of an arc fault is particularly high.

In some embodiments, according to the present application, it obtains high-frequency signals of the half-wave signal in three preset frequency bands by filtering and amplifying the amplified signal, wherein the three preset frequency bands do not overlap with each other. It calculates the arc energy values of the high-frequency signals of the half-wave signal in the three preset frequency bands, which are the first arc energy value, the second arc energy value and the third arc energy value, respectively. Then, the amplitude of the half-wave signal, the first arc energy value, the second arc energy value and the third arc energy value are compared with the corresponding threshold values. When the amplitude of the half-wave signal, the first arc energy value, the second arc energy value and the third arc energy value are all greater than the corresponding threshold values, determining that the arc signal includes a valid zero-crossing arc signal, and setting N=N+1, where N is the number of valid zero-crossing arc signals, and the initial value of N is zero. Whether the arc signal is faulty is identified based on the comparison result, thereby improving the accuracy of identification for arc fault of electrical device.

Step S50 includes:
S54, calculating the count value x of the signal whose voltage is greater than the high threshold voltage in the high-frequency signal in each preset frequency band;
S55, calculating the count value y of the signal whose voltage is greater than the low threshold voltage in the high-frequency signal in each preset frequency band, wherein the high threshold voltage is greater than the low threshold voltage;
S56, calculating arc energy values of high-frequency signals in at least two preset frequency bands according to x, y, and an energy coefficient k, where k is the energy coefficient of x.

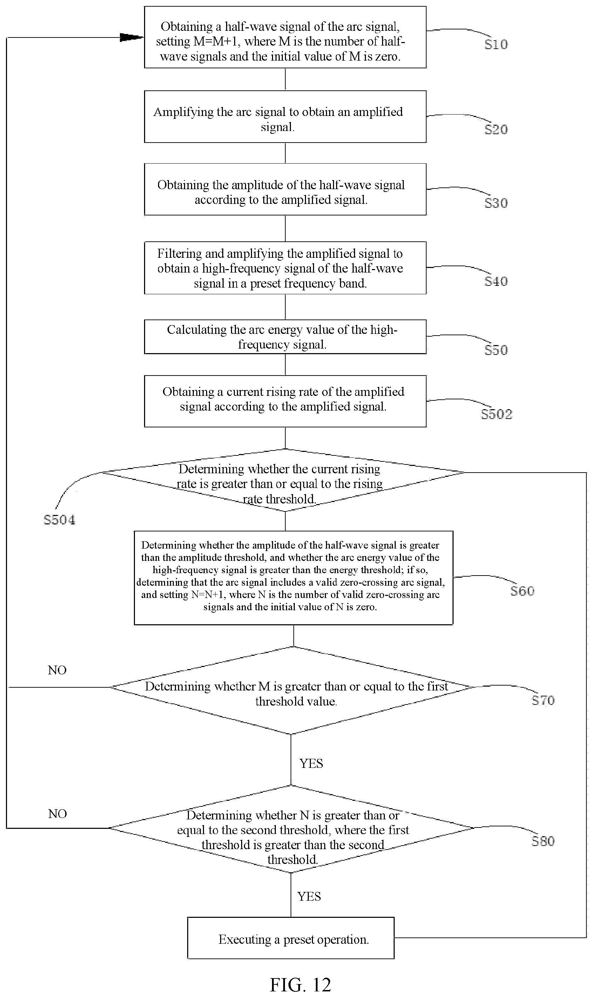

Please refer to FIG. 12, which is a flow chart of an arc signal processing method according to a second embodiment of the present application. The arc signal processing method provided in this embodiment is different from that provided in FIG. 9 in that:

Before Step S60, the arc signal processing method further includes:
S502, obtaining a current rising rate of the amplified signal according to the amplified signal;
S504, determining whether the current rising rate is greater than or equal to the rising rate threshold; if not, executing the next step; if so, issuing a fault alarm or disconnect the circuit that generates the arc signal.

Whether a series fault arc or a parallel fault arc occurs can be determined based on the current rising rate. For example, a parallel fault arc is similar to a short circuit, and the slope of the current is very large. When a parallel fault arc occurs, the current rising rate is greater than or equal to the rising rate threshold. Since the parallel fault arc is more dangerous, a fault alarm is issued or the circuit generating the arc signal is disconnected, thereby improving the safety performance of the electrical device.

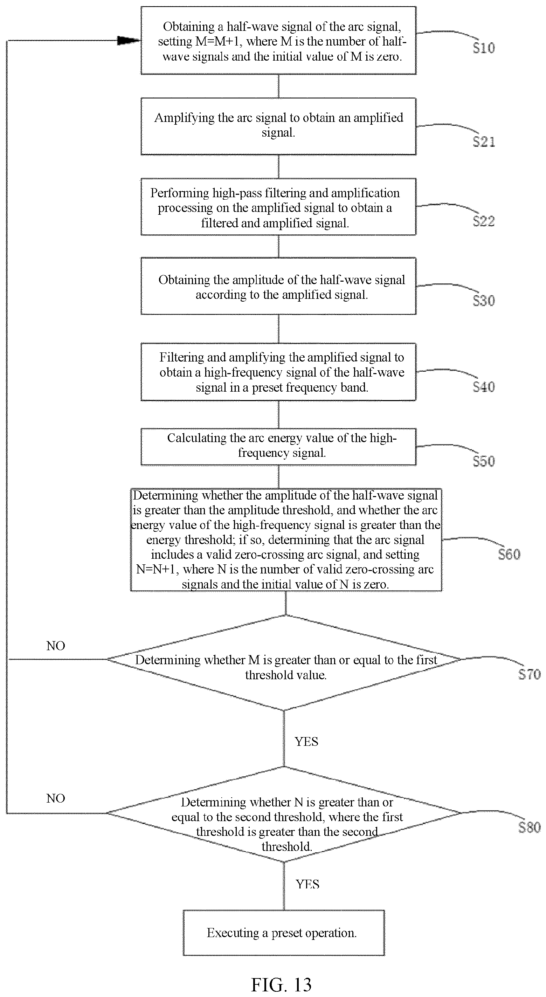

Please refer to FIG. 13, which is a flow chart of an arc signal processing method according to a third embodiment of the present application. The arc signal processing method provided in this embodiment is different from that provided in FIG. 9 in that:

Step S20 includes:
S21, amplifying the arc signal to obtain an amplified signal;
S22, performing high-pass filtering and amplification processing on the amplified signal to obtain a filtered and amplified signal;

Step S40 includes:
filtering and amplifying the filtered and amplified signal to obtain a high-frequency signal of the half-wave signal in a preset frequency band.

The amplified signal can be processed by high-pass filtering and amplification to more effectively improve the detection accuracy, thereby ensuring the accuracy of high-frequency signals.

In addition, the present application also provides an electrical device, which includes the above-mentioned arc signal processing circuit 100.

Compared with the prior art, the beneficial effects of the electrical device provided by the embodiments of the present application are the same as the beneficial effects of the arc signal processing circuit 100 provided by the above technical solution, which will not be repeated here.

The above is a detailed introduction to an arc signal processing circuit and electrical device provided in the embodiments of the present application. Specific examples are used in this article to illustrate the principles and implementation methods of the present application. The description of the above embodiments is only used to help understand the method of the present application and its core idea. For those skilled in the art, according to the ideas of the present application, changes can be made in the specific implementation methods and application scopes. **In** summary, the content of this specification should not be understood as a limitation on the present application.

## Claims

1. An arc signal processing circuit, **characterized in** comprising:
an amplification module, having an input end connected to an arc signal, and configured to amplify the arc signal and output an amplified signal;
a band-pass filtering amplification module, having an input end electrically connected to an output end of the amplification module, and configured to filter and amplify the amplified signal output from the amplification module and output a high-frequency signal in a preset frequency band; and
a main control module, electrically connected to the output end of the amplification module and to an output end of the band-pass filtering amplification module, and configured to receive the amplified signal output from the amplification module and the high-frequency signal output from the band-pass filtering amplification module.

2. The arc signal processing circuit according to claim 1, **characterized in that** the main control module comprises:
a high threshold voltage calculation unit, having an input end electrically connected to the output end of the band-pass filtering amplification module, and configured to calculate a count value of a signal whose voltage is greater than a high threshold voltage in the high-frequency signal output from the band-pass filtering amplification module; and
a low threshold voltage calculation unit, having an input end electrically connected to the output end of the band-pass filtering amplification module, and configured to calculate a count value of a signal whose voltage is greater than a low threshold voltage in the high-frequency signal output from the band-pass filtering amplification module; wherein the high threshold voltage is greater than the low threshold voltage;
wherein the main control module is configured to calculate an arc energy value of the high-frequency signal based on the count value of the signal whose voltage is greater than the high threshold voltage in the high-frequency signal, the count value of the signal whose voltage is greater than the low threshold voltage in the high-frequency signal, and an energy coefficient k, where k is an energy coefficient of the count value of the signal whose voltage is greater than the high threshold voltage in the high-frequency signal.

3. The arc signal processing circuit according to claim 1, **characterized in that** the amplification module comprises:
an amplification circuit, having an input end connected to the arc signal; and
a high-pass filtering amplification circuit, having an input end electrically connected to an output end of the amplification circuit, and an output end electrically connected to the input end of the band-pass filtering amplification module and the main control module respectively.

4. The arc signal processing circuit according to claim 3, **characterized in that** the output end of the amplification circuit is electrically connected to the main control module.

5. The arc signal processing circuit according to claim 2, **characterized in that** the band-pass filtering amplification module comprises:
a first band-pass filtering amplification circuit, having an input end electrically connected to an output end of the amplification module, and an output end electrically connected to the main control module; and
a second band-pass filtering amplification circuit, having an input end electrically connected to an output end of the amplification module, and an output end electrically connected to the main control module;
wherein a center frequency of the first band-pass filtering amplification circuit is smaller than a center frequency of the second band-pass filtering amplification circuit.

6. The arc signal processing circuit according to claim 5, **characterized in that** the high threshold voltage calculation unit comprises:
a first high threshold voltage calculation unit, having an input end electrically connected to the output end of the first band-pass filtering amplification circuit, and configured to calculate a count value of a signal whose voltage is greater than a first high threshold voltage in a high-frequency signal output from the first band-pass filtering amplification circuit; and
a second high threshold voltage calculation unit, having an input end electrically connected to the output end of the second band-pass filtering amplification circuit, and configured to calculate a count value of a signal whose voltage is greater than a second high threshold voltage in a high-frequency signal output from the second band-pass filtering amplification circuit;
wherein the low threshold voltage calculation unit comprises:
a first low threshold voltage calculation unit, having an input end electrically connected to an output end of the first band-pass filtering amplification circuit, and configured to calculate a count value of a signal whose voltage is greater than a first low threshold voltage in the high-frequency signal output from the first band-pass filtering amplification circuit; and
a second low threshold voltage calculation unit, having an input end electrically connected to the output end of the second band-pass filtering amplification circuit, and configured to calculate a count value of a signal whose voltage is greater than the second low threshold voltage in the high-frequency signal output from the second band-pass filtering amplification circuit;
wherein the first high threshold voltage is greater than the first low threshold voltage; the second high threshold voltage is greater than the second low threshold voltage.

7. The arc signal processing circuit according to claim 6, **characterized in that** the band-pass filtering amplification module further comprises:
a third band-pass filtering amplification circuit, having an input end electrically connected to the output end of the amplification module, and an output end electrically connected to the main control module;
wherein a center frequency of the third band-pass filtering amplification circuit is greater than the center frequency of the second band-pass filtering amplification circuit.

8. The arc signal processing circuit according to claim 7, **characterized in that** the high threshold voltage calculation unit further comprises:
a third high threshold voltage calculation unit, having an input end electrically connected to the output end of the third band-pass filtering amplification circuit, and configured to calculate a count value of a signal whose voltage is greater than a third high threshold voltage in a high-frequency signal output from the third band-pass filtering amplification circuit;
wherein the low threshold voltage calculation unit further comprises:
a third low threshold voltage calculation unit, having an input end electrically connected to the output end of the third band-pass filtering amplification circuit, and configured to calculate a count value of a signal whose voltage is greater than a third low threshold voltage in the high-frequency signal output from the third band-pass filtering amplification circuit;
wherein the third high threshold voltage is greater than the third low threshold voltage.

9. The arc signal processing circuit according to claim 2 or 6, **characterized in that** the high threshold voltage calculation unit comprises:
a first comparator, having a first input end connected to a signal having a high threshold voltage, and a second input end electrically connected to the output end of the band-pass filtering amplification module; and
a first timer, having an input end electrically connected to an output end of the first comparator.

10. According to the arc signal processing circuit of claim 2 or 6, wherein the low threshold voltage calculation unit comprises:
a second comparator, having a first input end connected to a signal having a low threshold voltage, and a second input end electrically connected to the output end of the band-pass filtering amplification module; and
a second timer, having an input end electrically connected to an output end of the second comparator.

11. The arc signal processing circuit according to claim 1, **characterized in that** the arc signal processing circuit further comprises:
a voltage sampling circuit, having an input end electrically connected to a circuit that generates an arc signal of an electrical device, and an output end electrically connected to the main control module, and configured to collect a voltage signal of the circuit that generates the arc signal.

12. An arc signal processing method, **characterized in** comprising:
obtaining a half-wave signal of an arc signal, setting M=M+1, where M is a number of the half-wave signals, and an initial value of M is zero;
amplifying the arc signal to obtain an amplified signal;
obtaining an amplitude of the half-wave signal according to the amplified signal;
filtering and amplifying the amplified signal to obtain a high-frequency signal of the half-wave signal in a preset frequency band;
calculating an arc energy value of the high-frequency signal;
determining whether the amplitude of the half-wave signal is greater than an amplitude threshold, and whether the arc energy value of the high-frequency signal is greater than an energy threshold; if so, determining that the arc signal comprises a valid zero-crossing arc signal, and setting N=N+1, where N is a number of the valid zero-crossing arc signals, and an initial value of N is zero;
determining whether M is greater than or equal to a first threshold; if not, obtaining a next half-wave signal of the arc signal; if so, executing a next step; and
determining whether N is greater than or equal to a second threshold which is smaller than the first threshold; if so, executing a preset operation; if not, obtaining a next half-wave signal of the arc signal.

13. The arc signal processing method according to claim 12, **characterized in that** calculating the arc energy value of the high-frequency signal comprises:
calculating a count value x of a signal whose voltage is greater than a high threshold voltage in the high-frequency signal;
calculating a count value y of a signal whose voltage is greater than a low threshold voltage in the high-frequency signal, wherein the high threshold voltage is greater than the low threshold voltage; and
calculating the arc energy value of the high-frequency signal according to x, y and an energy coefficient k, where k is an energy coefficient of x.

14. The arc signal processing method according to claim 12, **characterized in that** filtering and amplifying the amplified signal to obtain the high-frequency signal of the half-wave signal in the preset frequency band comprises:
filtering and amplifying the amplified signal to obtain a high-frequency signal of the half-wave signal in at least two preset frequency bands that do not overlap with each other;
wherein calculating the arc energy value of the high-frequency signal comprises:
calculating an arc energy value of the high-frequency signal in the at least two preset frequency bands;
wherein determining whether the amplitude of the half-wave signal is greater than the amplitude threshold, and whether the arc energy value of the high-frequency signal is greater than the energy threshold, comprises:
determining whether the amplitude of the half-wave signal is greater than the amplitude threshold, and whether the arc energy value of the high-frequency signal in each of the preset frequency bands is greater than the energy threshold; if so, determining that the arc signal comprises the valid zero-crossing arc signal, and setting N=N+1, where N is the number of valid zero-crossing arc signals, and the initial value of N is zero.

15. The arc signal processing method according to claim 14, **characterized in that** calculating the arc energy value of the high-frequency signal comprises:
calculating a count value x of a signal whose voltage is greater than a high threshold voltage in the high-frequency signal in each of the preset frequency bands;
calculating a count value y of a signal whose voltage is greater than a low threshold voltage in the high-frequency signal in each of the preset frequency bands, wherein the high threshold voltage is greater than the low threshold voltage; and
calculating the arc energy value of the high-frequency signal in the at least two preset frequency bands according to x, y and an energy coefficient k, where k is an energy coefficient of x.

16. The arc signal processing method according to claim 12 is **characterized in that** before determining whether the amplitude of the half-wave signal is greater than the amplitude threshold, and whether the arc energy value of the high-frequency signal is greater than the energy threshold, the arc signal processing method further comprises:
obtaining a current rising rate of the amplified signal according to the amplified signal;
determining whether the current rising rate is greater than or equal to a rising rate threshold; if not, executing a next step; if so, issuing a fault alarm or disconnecting a circuit generating the arc signal.

17. The arc signal processing method according to claim 12, **characterized in that** amplifying the arc signal to obtain the amplified signal comprises:
amplifying the arc signal to obtain the amplified signal; and
performing a high-pass filtering and amplification processing on the amplified signal to obtain a filtered amplified signal;
wherein filtering and amplifying the amplified signal to obtain the high-frequency signal of the half-wave signal in the preset frequency band comprises:
filtering and amplifying the filtered amplified signal to obtain the high-frequency signal of the half-wave signal in the preset frequency band.

18. An electrical device, **characterized in** comprising the arc signal processing circuit according to any one of claims 1 to 11.
